# EUROPEAN PATENT SPECIFICATION

(11) **EP 3 236 567 B1**
(45) Date of publication and mention of the grant of the patent: **09.06.2021**
(21) Application number: 16166005.5
(22) Date of filing: 19.04.2016
(51) Int. Cl.: H02M 1/08, H02M 7/5387, H03K 17/16, H02M 1/00

(54) **A VOLTAGE SOURCE CONVERTER AND A METHOD FOR CONTROL THEREOF**
SPANNUNGSQUELLENUMRICHTER UND VERFAHREN ZUR STEUERUNG DAVON
CONVERTISSEUR DE SOURCE DE TENSION ET PROCÉDÉ DE SON COMMANDE

(43) Date of publication of application: 25.10.2017
(73) Proprietor: Bombardier Transportation GmbH, 10785 Berlin (DE)
(72) Inventor: Velander, Erik, SE-723 41 Västerås (SE)
(74) Representative: Bjerkéns Patentbyrå KB (Gävle)

(56) References cited:
- DE-A1- 19 746 112
- DE-A1-102011 077 387
- DE-B3-102005 012 151
- US-A1- 2007 189 048
- US-A1- 2014 312 817
- US-A1- 2014 334 214

## Description

### TECHNICAL FIELD OF THE INVENTION AND BACKGROUND ART

The present invention relates to a voltage source converter comprising
- a half bridge with two current valves connected in series and configured to be connected to opposite poles of a DC source/load, each said current valve comprising a semiconductor device of turn-off type and a rectifying diode connected in anti-parallel therewith, a midpoint of the half bridge between the two current valves forming an AC side of the converter and being configured to be connected to an AC load/source, and
- a gate drive unit having a first gate drive part configured to control the semiconductor device of a first of the current valves and a second gate drive part configured to control the semiconductor device of the other, second of the current valves to turn on and off according to a Pulse Width Modulation pattern for creating a fundamental AC voltage and current on said AC side, each gate drive part including a control unit configured to control a drive member configured to influence gate parameters of the semiconductor device to be controlled by that gate drive part, as well as a method for controlling a voltage source converter according to the preamble of the appended independent method claim.

The invention is not restricted to any particular use of such a converter, but the use thereof in a track-bound vehicle, such as a rail vehicle, will hereinafter be explained for illuminating the invention but accordingly not restrict the invention to that application.

Such a converter is used for converting a direct voltage to an alternating voltage or vice versa for different purposes. Thus, either the AC side is considered to be the load and the DC side the source as for a motor converter or conversely as for a line converter. The invention is not restricted to any number of phases of the voltage applied to a said AC side, although single phase and three phase voltages are most common, neither is the invention restricted to any particular levels of such voltages or electric power to be fed through the converter. Thus, in the case of three phase voltages the converter has three said half bridges connected in parallel between the opposite poles of the DC side.

The semiconductor device of the current valves may be any semiconductor device of turn-off type, for example an IGBT or a MOSFET.

The gate drive unit of the converter may have said two gate drive parts integrated in one single part or include them as two physically separated parts. The same applies for the control units of the gate drive parts.

The control of the converter turns on one of the valves at a time in order to produce a Pulse Width Modulated (PWM) voltage on the AC side with the desired magnitude, frequency and phase angle of its fundamental Fourier component. As there usually is an inductive impedance on the AC side the current will mainly consist of the fundamental sinus wave. During the half period of the fundamental when the current flows into the AC side of the converter it will either flow through the IGBT of the lower valve or through the diode of the upper valve. Which of these to paths the current takes at a certain moment is controlled by the turn-on and turn-off of said lower IGBT: When the lower side IGBT is on (i. e. conducting) the current flows through it and when it is off (i. e. not conducting) the current has to flow through the diode of the upper valve. The other IGBT, in this case the upper, will in many cases be driven more or less in antiphase, i. e. it will be turned on when the lower IGBT is turned off, but as long as the current flows into the AC side and through the diode of the upper valve this makes no difference to the voltage on the AC side. During this half period it is therefore the lower IGBT that is controlling the voltage on the AC side. During the other half period of the fundamental the current flows out the AC side of the converter, either through the IGBT of the upper valve or through the diode of the lower valve, controlled by the turn-on and turn-off of said upper IGBT, so during this other half period it is therefore the upper IGBT that is controlling the voltage on the AC side.

The phase voltage slew rate, which corresponds to the diode reverse recovery dV/dt of the diode of the current valve not controlling the voltage on the AC side, is an important design factor for a voltage source converter of this type which must be limited in all working points in terms of temperature and commutated voltage and current. The gate drive unit controlling the turn-on process of the semiconductor device results in an indirect control of the diode reverse recovery dV/dt, i.e. the diode turn-off dV/dt. In order to utilise the low stray inductance of such a voltage source converter the switching speed of the semiconductor devices must be increased, which results in higher dV/dt. In the case of bipolar rectifying diodes and semiconductor devices in the form of IGBTs the highest diode reverse recovery dV/dt occurs at a low current on said AC side of the converter, which means that the IGBT has for such low currents to be turned on slowly. That is no problem since the turn-on losses in the IGBT will then in any way be low, but if the same turn-on speed is used for higher currents the turn-on losses will be substantial, and the IGBTs will then have to be dimensioned for such higher losses making them more expensive. Furthermore, thermic cycling of the IGBT will then occur resulting in a shortened lifetime thereof. The economic value of the accumulated energy loss is also considerable.

The article "Innovative IGBT Driver IC Resolves Dilemma of Gate Resistor Selection" in Issue 5 2014 of Power Electronics Europe discloses a voltage source converter of the type defined in the introduction trying to solve the problem with higher turn-on losses in the IGBTs for higher currents on the output to said AC load. This is done by making the control of the IGBTs depending upon the current on said output, so that the IGBT is controlled to turn-on softly when it is operating at low current levels and to turn-on quickly at higher current levels. However, to measure said current requires additional communication links and also a current sensor being sufficiently fast operating resulting in a complex control scheme and considerable costs for obtaining the control aimed at.

A voltage source converter of the type defined in the introduction and trying to address the problem just mentioned is disclosed in US 2014/312817 A1 and involves a closed loop control, in which the voltage across the rectifying diode is measured during the switching transient and the gate current is adapted depending on the time profile of that voltage. This is shown by the expression for the gate current as a function of time, where i_{G}(t) for both turn-on and turn-off is expressed as linear functions of u_{FD}(t), i.e. the voltage across the freewheeling diode at the same time.

### SUMMARY OF THE INVENTION

The object of the present invention is to provide a voltage source converter and a method for controlling the turn-on of a semiconductor device of turn-off type in a voltage source converter of the type defined in the preambles of appended independent converter and method claims being improved with respect to such converters and methods already known.

This object is according to the invention obtained by providing such a voltage source converter and method with the features listed in appended independent claims directed thereto.

Thus, in the invention there is no closed loop feedback, but the measurement of the voltage across the rectifying diode is performed before the switching order and the result is used as a measure of the load current, at that instant flowing as forward current through the rectifying diode. The control does subsequently use a priori known information on the appropriate gate current variation in time for controlling the turn-on of the semiconductor device of the other current valve at that load current.

Furthermore, by measuring the voltage across the rectifying diode of the current valve not controlling the voltage on the AC side, using the value of this voltage measured as a measure of the current on the AC side of the converter and making the turn-on control of the semiconductor device in the current valve controlling the voltage on the AC side dependent upon this measure the diode reverse recovery dV/dt of the diode of the current valve not controlling the voltage on the AC side may be kept on a desired level while adapting the turn-on speed of the semiconductor device controlling the voltage on the AC side to the current on the AC side of the converter. This way of addressing the above problem results in a simpler control and a possibility to carry out this quicker than for the voltage source converter disclosed in the above document. The benefit of the invention is particularly high in the case of semiconductor current valves for which the diode turn-off dV/dt is higher for lower currents than for higher currents when the semiconductor devices are driven independently of the load current. This is for example usually the case with a bipolar diode used with an IGBT. In this case the control units of the gate drive parts may be configured to make the turn-on speed of the semiconductor device of the current valve higher the higher the measure of the current is, which will reduce the total switching losses associated with the turn-on in the operating points where the semiconductor losses and temperature are likely to be limiting. "To use the voltage measured as a measure of the current on said AC side" is to be interpreted broadly and to also cover the case where no intermediate result in the form of a current measure is obtained but the parameters controlling the output of the gate drive parts are directly determined from at least the voltage across the diode.

US 2009/0057832 A1 discloses a converter in which the voltage drop across a diode is measured and used for the control of the semiconductor device connected directly across this diode for reducing diode conduction losses. WO 2011/160729 A1 may also be mentioned in this context as a document disclosing a converter in which the voltage across a diode is measured, but this document is occupied with particular problems arising in the case of connecting a plurality of current valves in series.

According to an embodiment of the invention the voltage source converter comprises, for at least one current valve, a member configured to measure the temperature of that valve in the vicinity of the diode of the valve and send information thereabout to the gate drive part associated with the other current valve, which is configured to receive such temperature (T) information and consider also this information as a parameter when determining the measure of the current on said AC side and make the control of said drive member thereof also depending upon information about the value of the temperature measured. In the case that only one current valve is equipped with a member configured to measure the temperature of that valve in the vicinity of its diode the information thereabout is also sent to the gate drive part associated with this current valve, which is configured to use this temperature (T) information as a best available approximation of the temperature of the diode of the other valve, together with the value of the voltage measured across the diode of the other valve, when determining the measure of the current on said AC side and make the control of said drive member thereof also depending upon information about the value of the temperature measured. It is known that the dependency of the current on the AC side upon the voltage across the rectifying diode is dependent upon the temperature of the diode in question, so that the control of the semiconductor devices of the converter in dependence upon the current on the AC side of the converter may then be very precise while carefully observing the maximum limit of said dV/dt, irrespectively of the operating conditions of the converter. Each current valve may have a temperature measuring member, but as the thermal load of the two valves is expected to be similar the temperature of the two diodes should also be similar if the cooling of the half bridge module is uniform and the module has equal thermal impedance from both diodes to the baseplate, so that it should be sufficient with only one temperature measuring member per half bridge measuring the temperature of one diode and using the value thereof for both diodes.

According to another embodiment of the invention each gate drive part comprises a transceiver configured to communicate with a transceiver of the other gate drive part so as to transmit said information between the gate drive parts. This enables transmitting of information necessary for carrying out the invention between the two gate drive parts in the case of physically separated such parts. "Transceiver" as used here and in the claims is to be interpreted to also cover a combination of a transmitter and a receiver separate from each other.

According to two other embodiments of the invention each gate drive part comprises a look-up table unit configured to receive said information to be used
- in one case to determine a measure of the current on said AC side and to determine said measure of the current by comparing said information with data stored in tables of this unit and send information of this measure to the control unit of this gate drive part configured to control the gate member in dependence thereupon
- in the other case to directly determine a suitable control signal for the turn on of the semiconductor and send it to the control unit.

This constitutes a reliable way of obtaining control of the semiconductor devices in dependence upon the current on the AC side of the converter for observing the requirement of the dV/dt of the freewheeling diode in the current valve presently not controlling the voltage on the AC side. Such dv/dt requirements are imposed by EMC considerations and by the winding insulations of the inductive component connected on the AC side of the converter, e. g. a motor, a transformer or a filter inductor. Such a use of a look-up table constitutes a preferred embodiment, but the same task may as an alternative be achieved by using a device which calculates/approximates via equations (for example via curve fitting, etc.).

According to another embodiment of the invention the gate drive parts have drive members in the form of current sources and the control units are configured to control the drive members to influence a turn-on current to the semiconductor device of the associated current valve influencing the turn on behaviour of the semiconductor device. This is one example of a said drive member indicating how "drive member" is to be interpreted in this disclosure.

According to another embodiment of the invention each gate drive part has a drive member in the form of a voltage source and a gate resistor and at least one of said voltage source and gate resistor is controllable and the control unit is configured to control the drive member to influence a gate voltage of the semiconductor device of the associated current valve influencing the turn on behaviour of the semiconductor device.

According to another embodiment of the invention the gate drive parts have drive members according to a further alternative including a variable gate resistor and a fixed voltage source connected thereto and the control units are configured to control the drive members to vary the resistance of said gate resistor of the associated current valve so as to influence the conduction behaviour the semiconductor device.

According to another embodiment of the invention said rectifying diode of each current valve is in one case a diode separated from the semiconductor device of the current valve and in the other case the rectifying diode is a built-in diode in the same semiconductor body as the semiconductor device of the respective current valve. Accordingly, also the latter case of a diode built-in in the same semiconductor body is to be included in the present invention.

According to another embodiment of the invention the voltage source converter comprises, for at least one current valve, a member configured to measure the voltage across that valve while it is not conducting, which is in practice the voltage across the DC source/load, and send information thereabout to the gate drive part associated with the same current valve, which is configured to receive such voltage (V_{ce}) information and use also this information as a parameter when determining the control of said drive member thereof so as to minimize the total switching losses associated with the turn on of the semiconductor device while still keeping the diode reverse recovery dV/dt of the diode of the current valve not controlling the voltage on the AC side below a maximum level allowed, which for this embodiment may be dependent on the magnitude of the voltage step magnitude. By making the gate drive adapt also to the magnitude of the voltage step, which is largely equal to the voltage (V_{ce}) across the valve, the total switching losses associated with the turn-on of the semiconductor device can be reduced for all voltages (= voltage step magnitudes) where the maximum allowed diode reverse recovery dv/dt is higher than the lowest maximum diode reverse recovery dv/dt allowed for any voltage. As the maximum diode reverse recovery dv/dt level is lower for a larger voltage step, i. e. for a higher value of the voltage (V_{ce}) across the valve this embodiment will result in lower switching losses for all but the highest voltage step values. For a train operating on a DC line these highest voltage steps will primarily occur while braking. For a train operating on an AC line these highest voltage steps will only occur during transients, constituting a negligible part of the total operating time. In the case that only one current valve is equipped with a member configured to measure the voltage across that valve the information thereabout is also sent to the gate drive part associated with the other current valve. By the time said other current valve is turning on said current valve equipped with a member configured to measure the voltage is conducting, so the best available information about the voltage across the valve turning on is the latest transmitted value of the voltage (V_{ce}). Each current valve may have a voltage measuring member, but as the voltage across the DC source/load is expected to vary only by a small amount between a turn-on in one of the valves and the turn-on in the other valve such a latest transmitted value will be a good approximation to the actual voltage across the current valve turning on.

According to another embodiment of the invention the semiconductor devices of the current valves are IGBTs (Insulated Gate Bipolar Transistors) or MOSFETs (Metal Oxide Semiconductor Field Effect Transistors).

According to another embodiment of the invention the rectifying diodes are bipolar diodes. At least in the case of the semiconductor devices being IGBTs the diode turn-off dV/dt is then higher for lower currents than for higher currents, so it is preferred to have the control units of the gate drive parts configured to make the turn-on drive of the semiconductor device of the current valve higher the higher the measure of the current on said AC side is, since this will increase the turn on speed and reduce the total switching losses without increasing said dV/dt above the applicable limit.

According to another embodiment of the invention the rectifying diodes are unipolar diodes and the control unit of each gate drive part is configured to make the turn-on drive of the semiconductor device of the current valve controlling the voltage on the AC side lower with a higher measure of the current on said AC side determined. With a unipolar diode is meant a diode where the current conduction in the concerned current range only is influenced by the participation of one kind of charge carriers, electrons or holes. This can be a Schottky diode or a Junction Barrier Schottky diode. In the case of having a unipolar diode connected in anti-parallel with the semiconductor device and conventional gate drives turning on the semiconductor devices independently of the current magnitude on the AC side, the diode reverse recovery dV/dt of the diode of the current valve not controlling the voltage on the AC side will increase with the current on the AC side of the converter. If the gate drive is then adjusted to keep the dV/dt below the maximum allowed also for unusually high currents, e. g. higher than at the thermally limited maximum continuous output current, the total switching losses associated with the turn on at normal currents will be higher than optimal. By making the turn-on drive of the semiconductor device of the current valve controlling the voltage on the AC side higher with a lower measure of the current on the AC side determined possible to reduce the switching losses in normal operation while observing the dV/dt - requirement also for the unusually high currents.

According to another embodiment of the invention the converter is a track-bound vehicle converter configured to be arranged on board a track-bound vehicle and being for example a motor converter configured to deliver power through said AC side of the converter to a motor used to drive the vehicle or an auxiliary converter configured to deliver a voltage on said AC side of the converter to be used for the heating/cooling system of the vehicle and for electrical appliances, such as through sockets arranged in said vehicle. This is a preferred application of a voltage source converter of this type.

According to another embodiment of the invention the control units of the gate drive parts are configured to turn-on and off the current valves with a frequency of 0.3 kHz - 100 kHz.

According to another embodiment of the invention the converter is configured to deliver a power of 10 kVA - 4 MVA on the output of the converter. In the case of an auxiliary converter the power will mostly be 10 kVA - 300 kVA and for a motor converter and a line converter the power will normally be in the range of 70 kVA - 4 MVA.

The invention also relates to a method for controlling the turn on of a semiconductor device of turn-off type in a voltage source converter according to the appended independent method claim, and the advantages of such a method and possible embodiments thereof appear clearly from the above discussion of the voltage source converter according to the invention.

The invention also relates to a track-bound vehicle having at least one converter according to the invention resulting in a number of advantages disclosed above, such as reduction of costs for components and maintenance.

Further advantages as well as advantageous features of the invention will appear from the following description of an embodiment of the invention.

### BRIEF DESCRIPTION OF THE DRAWINGS

With reference to the appended drawings, below follows a specific description of an embodiment of the invention cited as an example. In the drawings:
- Fig 1: is a very schematic view illustrating how different types of converters of the type to which the present invention is directed may be arranged and controlled in a track-bound vehicle,
- Fig 2: is a schematic circuit diagram of a converter according to an embodiment of the present invention,
- Fig 3: is a simplified graph illustrating the current on the AC side of the converter versus the voltage across the freewheeling diode for different temperatures of the diode.
- Fig 4: is a graph showing the diode turn-off dV/dt versus commutated current for the case of making the turn-on gate drive of the IGBTs dependent upon the commutated current in comparison with the case of having a constant turn-on gate drive of the IGBTs adapted to fulfil the dV/dt requirements at all currents, and
- Fig 5: is a graph showing the total switching losses in an IGBT and a bipolar diode for the case of adapting the turn-on gate drive to the current and the case of constant turn-on gate drive.

### DETAILED DESCRIPTION OF AN EMBODIMENT OF THE INVENTION

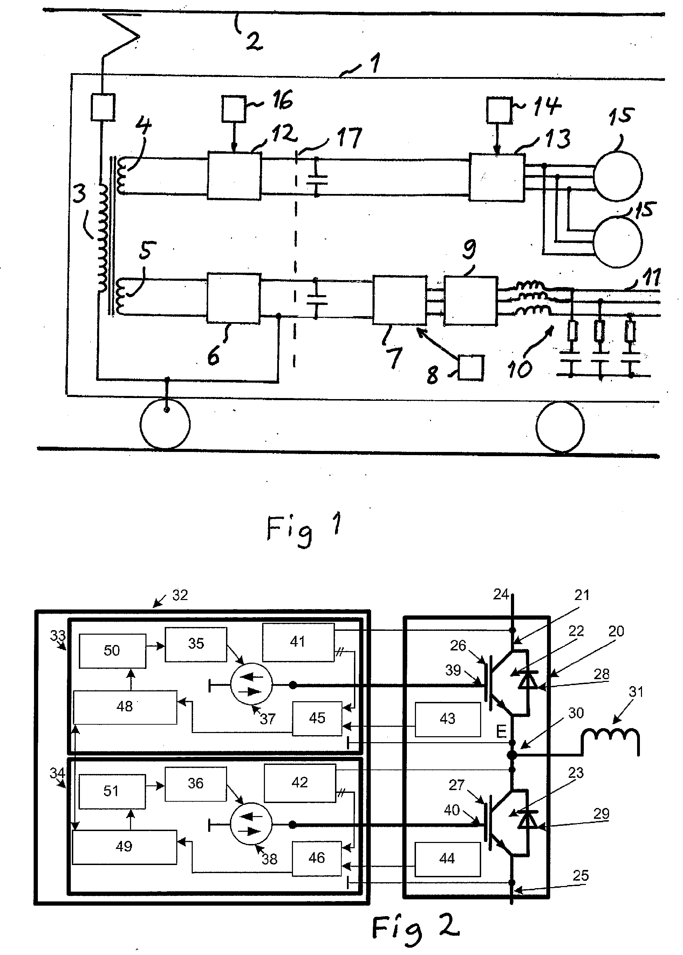

Since the present invention is particularly suited for being used in track-bound vehicles some possible ways of using a voltage source converter according to the invention will now be briefly described with reference made to Fig 1 without restricting the invention to this field of use. Fig 1 illustrates schematically how electric power may be fed to a track-bound vehicle 1 from an AC-supply line 2 and used in said vehicle. The vehicle is configured to move along the AC-supply line 2, which accordingly acts as an AC-source and which may for example carry a one-phase alternating voltage of 15 kV and 16 2/3 Hz (Sweden, Germany etc.) and 25 kV and 50 Hz (Denmark, China, India etc.). The vehicle has a transformer 3 for transforming the voltage from the supply line 2 to a suitable level. The transformer has here two secondary windings 4, 5, one of which being connected to a line converter 6 for delivering a direct voltage of for example 1.5 - 3 kV on the output thereof. This direct voltage is delivered to an auxiliary converter 7, which is controlled by a converter controller 8 for generating a train of pulses according to a Pulse Width Modulation pattern for delivering a three-phase alternating voltage on the output thereof. The output of this converter is connected to a three-phase transformer 9 as well as harmonic filters 10 for smoothing out the alternating voltage delivered by a distribution network 11 to sockets arranged in the track-bound vehicle, such as for connection of computers, and to lightning, heating and other appliances. Such transformers and filter inductors also have dv/dt limitations.

The other secondary winding 4 of the transformer is connected to a line converter 12 configured to deliver direct voltage on the output thereof to the input of a motor converter 13 for delivering a three-phase alternating voltage on the output thereof to motors 15 in the form of electric machines, for driving the vehicle. Each converter 12, 13 is controlled by a converter controller 16, 14 which determines the PWM pattern of the converter. The motor converter controller 14 will receive orders from the driver of the vehicle for adapting the frequency (induction machines) or phase angle (permanent magnet machines) of the fundamental voltage delivered to the stator windings of the motors to the tractive effort/traction force commanded. In the case of braking the vehicle electric power will flow in the direction from the motors to the AC-supply line through the line converter 12 controlled to deliver a single phase alternating voltage on the AC side thereof. The converters 6, 7, 12 and 13 may be voltage source converters according to the present invention. It is pointed out that the electric system shown in Fig 1 is only one of several possible appearances of an electric system in a track-bound vehicle.

A single phase of a voltage source converter according to an embodiment of the invention is schematically illustrated in Fig 2. The voltage source converter has for each phase a half bridge module 20 having a half bridge 21 with two current valves 22, 23 connected in series and configured to be connected to opposite poles 24, 25 of a DC source or load, such as a DC voltage intermediate link connected to the converters 7 and 13 shown in Fig 1. Each current valve has a semiconductor device 26, 27 of turn-off type in the form of an IGBT and a rectifying diode 28, 29 connected in anti-parallel therewith. A midpoint of the half bridge between the two current valves forms an AC side 30 of the converter and is configured to be connected to an inductive impedance, in this case an AC load 31. The voltage source converter has for each phase a gate drive unit 32 with a first gate drive part 33 configured to control the IGBT 26 of the first current valve 22 and a second gate drive part 34 configured to control the IGBT 27 of the other, second current valve 23 to turn on and off according to a Pulse Width Modulation pattern for creating an AC voltage and current on the AC side 30.

Each gate drive part 33, 34 has a control unit 35, 36 configured to control a drive member 37, 38 configured to influence gate parameters of the respective IGBT 26, 27, and these drive members are here current sources connected to the gates 39, 40 of the IGBTs for feeding a current to the gate influencing the conduction behaviour of the IGBT. Each gate drive part 33, 34 has a member 41, 42 configured to measure the voltage across the rectifying diode 28, 29 at least during the half period of the AC current on the AC side 30 when the IGBT 27, 26 of the other current valve is controlling the voltage on the AC side. These voltage measuring members 41, 42 are accordingly measuring the forward voltage V_{f} across the freewheeling diode 28, 29 of the current valve not controlling the voltage on the AC side by sensing the collector-emitter voltage V_{ce} of the IGBT connected in antiparallel with the freewheeling diode, and these members 41, 42 are integrated into the respective gate drive part 33, 34.

The converter has also for each current valve a member 43, 44 configured to measure the temperature of that valve in the vicinity of the diode 28, 29 of the valve. The members 41, 42 and the members 43, 44 are configured to send information about the forward voltage of the freewheeling diode V_{f} and the temperature T, respectively, to an analogue to digital converter 45, 46 and further to a transceiver 48, 49 configured to communicate with a transceiver of the other gate drive part so as to transmit said information to that gate drive part. Accordingly, the information about V_{f} and T of the current valve 22 is received by the transceiver 49 of the gate drive part 34 for being used to control the IGBT of the other current valve 23 and vice versa.

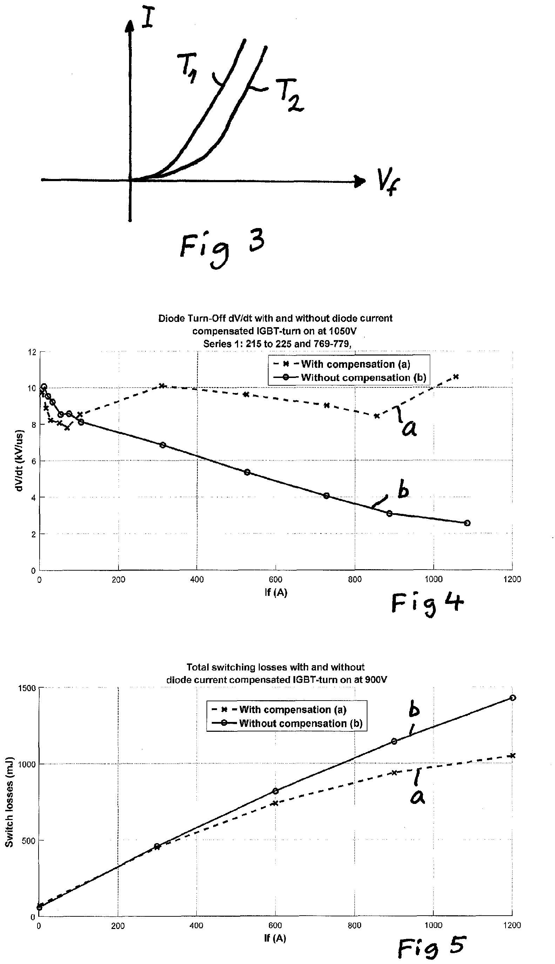

Fig 3 illustrates how the current I through the freewheeling diode is depending upon the forward voltage V_{f} and the temperature at the junction of the diode, in which T₁ is -40°C and T₂ is +100°C. Accordingly, if the forward voltage and the temperature are known an accurate measure of the current through the diode and by that on the AC side 30 may be obtained. Each control unit 35, 36 of the gate drive parts is configured to consider the voltage measured across the freewheeling diode as a measure of the current on said AC side 30 while also considering the temperature measured close to the freewheeling diode. Each gate drive part has a look-up table unit 50, 51 configured to receive information from the transceiver 48, 49 in the form of V_{f} and T of the current valve associated with the other gate drive part to be used to determine a measure of the current on the AC side. Each look-up table unit is configured to determine said measure of the current by comparing said information with data stored in tables of this unit and send information of this measure to the respective control unit 35, 36, which is configured to control the current source 37, 38 in dependence upon the current through the freewheeling diode of the other current valve and preferably also upon the junction temperature of the involved diode (and of the IGBT, which may be assumed to have approximately the same temperature). Accordingly, during the half period of the AC current on the AC side 30 when the IGBT 26 of the current valve 22 is controlling the voltage on the AC side this control is carried out by controlling the current source 37 through the control unit 35 in dependence of information about the forward voltage V_{f} and the temperature T of the freewheeling diode 29 of the other current valve 3 and by that of the current on the AC side 30 to the load 31.

Furthermore, the control unit 35 is configured to make the control of the drive member (current source) 37 dependent upon said current I through the freewheeling diode 29 of the current valve 23 so as to at all current magnitudes keep the diode reverse recovery dV/dt of the diode 29 below a maximum level allowed while minimizing the total switching losses associated with the turn on of the semiconductor device 26, i. e. the sum of the semiconductor device 26 turn on loss and the diode 29 reverse recovery loss. If the gate drive is kept independent of diode current and temperature a lower said current I will result in a higher diode reverse recovery dV/dt. According to the invention the IGBT is instead turned on slowly, i.e. through a low turn-on current from the current source, for a low diode current, thereby keeping diode reverse recovery dv/dt below the maximum level, but at higher diode current the IGBT is turned on faster, i. e. through a higher turn-on current from the current source, thereby keeping total switching losses down while still not exceeding the maximum diode reverse recovery dv/dt limit. The switching losses dissipated in the IGBT are depending upon the current I and how fast the IGBT is turned on, so that the IGBT may be turned on slowly if the current is low without causing any harmful losses in the IGBT. However, when the control units 35, 36 of the respective gate drive part receive information about a higher current I that means that said diode reverse recovery dV/dt will tend to be lower, so that the control unit may then drive the turn-on of the IGBT with a higher current from the current source to turn on faster keeping the losses in the IGBT at a low level in spite of the higher current I.

Thus, by having the control unit 35, 36 of each gate drive part configured to control the associated drive member (current source) so as to keep the diode reverse recovery dV/dt of the diode of the current valve not controlling the voltage on the AC side at an as far as possible constant level, irrespective of the current on the AC side 30, the total switching losses caused by the turn on of the IGBT may be reduced the more the higher the current I.

Fig 4 is a graph showing the diode turn-off dV/dt versus the current I of the freewheeling diode for the case of b) no compensation of the control of the IGBT-turn on and a) according to the invention with compensation obtained by using information about the current to turn on faster at higher currents. V_{ce} is in this case 1050 V. The gate drive unit setting without compensation was optimized at 60°C meaning that the dV/dt is higher at lower temperatures. The dV/dt values are obviously significantly lower for the non-compensated gate control for higher currents than for lower currents, while the compensated values are rather similar for lower and higher currents.

Fig 5 is a graph showing the total switching losses SL in the entire current valve 22, 23 versus the current I in the freewheeling diode for the two control schemes, without compensation b) and with compensation a), shown in Fig 4. The same gate drive units as for the measurements shown in Fig 4 were used here, but the measurements were carried out at 125°C semiconductor junction temperature where the switching losses are higher than at 60°C. The total switching losses with and without freewheeling diode current compensated IGBT-turn on at 900 V are shown, and it appears that the total switching loss reduction by using the current compensation in the voltage source converter according to the invention increases with commutated current and is as high as 27 % at a current of 1200 A.

The invention is of course not restricted to the embodiment described above, but many possibilities to modifications thereof would be apparent to a person with skill in the art without departing from the scope of invention as defined in the appended claims.

As already mentioned above, active control of a semiconductor device of turn-off type of the respective current valve could be achieved otherwise than disclosed, for instance by using gate voltage control or varying a gate resistor with a fixed voltage source, and the semiconductor device may be of another type than an IGBT, for instance a JFET or a MOSFET for which the diode reverse recovery dV/dt may have another dependency upon the commutated current than for an IGBT.

It is not an essential feature of the invention to keep the diode reverse recovery dV/dt at or above a certain level, but to minimize the switching losses in average and in particular for the operating conditions that put the most severe limitation on performance of the converter and thereby also on the vehicle where the converter is used. There may be combinations of semiconductor device (IGBT or MOSFET) and diode that cannot reach anywhere near the maximum diode reverse recovery dv/dt limit at some current / temperature combination, but if this is only at a low current or low temperature this is of no concern as these operating conditions only represent a very minor part of normal operation and do not put severe limitation on equipment or vehicle performance.

It is within the scope of the invention to have the member measuring the voltage across a rectifying diode of a current valve included in the gate drive part configured to control the semiconductor device of the other current valve, which would then make a communication between the two gate drive parts by transceivers superfluous. However, this solution would involve more complex insulation coordination and also be more complex in terms of EMI behaviour (interference suppression) and requires additional measures.

## Claims

1. A voltage source converter comprising
• a half bridge (21) with two current valves (22, 23) connected in series and configured to be connected to opposite poles (24, 25) of a DC source/load, each said current valve comprising a semiconductor device (26, 27) of turn-off type and a rectifying diode (28, 29) connected in anti-parallel therewith, a midpoint of the half bridge between the two current valves forming an AC side (30) of the converter and being configured to be connected to an AC load/source (31), and
• a gate drive unit (32) having a first gate drive part (33) configured to control the semiconductor device (26) of a first of the current valves and a second gate drive part (34) configured to control the semiconductor device (27) of the other, second of the current valves to turn on and off according to a Pulse Width Modulation pattern for creating an AC fundamental voltage and current on said AC side (30), each gate drive part including a control unit (35, 36) configured to control a drive member (37, 38) configured to influence gate parameters of the semiconductor device to be controlled by that gate drive part,
***characterized* in that** the converter comprises, for each current valve (22, 23), a member (41, 42) configured to firstly measure the voltage (V_{f}) across said rectifying diode (28, 29) of the current valve at least during the half period of the AC current on said AC side when the semiconductor device (27, 26) of the other current valve is controlling the voltage on the AC side and secondly send information about the voltage measured to the control unit (35, 36) of the gate drive part associated with said other current valve controlled, that the control unit of each gate drive part (33, 34) is configured to use the voltage measured as a measure of the current (I) on said AC side and make the control of said drive member (37, 38) thereof depending upon information about said measure so as to minimize the total switching losses associated with the turn on of the semiconductor device while still keeping the diode reverse recovery dV/dt of the diode (28, 29) of the current valve not controlling the voltage on the AC side below a maximum level allowed, and that the voltage source converter is configured to be connected on its AC side to an inductive impedance.

2. A voltage source converter according to claim 1, ***characterized* in that** it comprises, for at least one current valve (22, 23), a member (43, 44) configured to measure the temperature of that valve in the vicinity of the diode (28, 29) of the valve and send information thereabout to at least the control unit (35, 36) of the gate drive part associated with the other current valve, and that the control unit of each gate drive part (33, 34) is configured to receive such temperature (T) information and consider also this information as a parameter when determining the measure of the current (I) on said AC side (30) and make the control of said drive member (37, 38) thereof also depending upon information about the value of the temperature measured.

3. A voltage source converter according to any of the preceding claims, ***characterized* in that** each gate drive part (33, 34) comprises a transceiver (48, 49) configured to communicate with a transceiver (48, 49) of the other gate drive part so as to transmit said information between the gate drive parts.

4. A voltage source converter according to any of the preceding claims, ***characterized* in that** each gate drive part (33, 34) comprises a look-up table unit (50, 51) configured to receive said information to be used to determine a measure of the current (I) on said AC side (30) and to determine said measure of the current by comparing said information with data stored in tables of this unit and send information of this measure to the control unit (35, 36) of this gate drive part configured to control the drive member (37, 38) in dependence thereupon.

5. A voltage source converter according to any of claims 1-3, ***characterized* in that** each gate drive part (33, 34) comprises a look-up table unit (50, 51) configured to receive said information and to determine values for the control of the gate drive by comparing said information with data stored in tables and to send the values to the control unit (35, 36) of this gate drive part configured to control the drive member (37, 38) in dependence thereupon.

6. A voltage source converter according to any of the preceding claims, ***characterized* in that** the gate drive parts (33, 34) have drive members (37, 38) in the form of current sources and the control units (35, 36) are configured to control the drive members to influence a turn-on current to the semiconductor device (26, 27) of the associated current valve (22, 23) influencing the turn on behaviour of the semiconductor device.

7. A voltage source converter according to any of the preceding claims, ***characterized* in that** each gate drive part (33, 34) has a drive member (37, 38) in the form of a voltage source and a gate resistor and at least one of said voltage source and gate resistor is controllable and that the control unit (35, 36) is configured to control the drive member to influence a gate voltage of the semiconductor device (26, 27) of the associated current valve (22, 23) influencing the turn on behaviour of the semiconductor device.

8. A voltage source converter according any of the preceding claims, ***characterized* in that** it comprises, for at least one current valve (22, 23), a member (41, 42) configured to measure the voltage across that valve while it is not conducting and send information thereabout to at least the control unit (35, 36) of the gate drive part associated with the same current valve, and that the control unit of each gate drive part (33, 34) is configured to receive such voltage (V_{ce}) information and use also this information as a parameter when determining the control of said drive member (37, 38) thereof so as to minimize the total switching losses associated with the turn on of the semiconductor device while still keeping the diode reverse recovery dV/dt of the diode (28, 29) of the current valve not controlling the voltage on the AC side below a maximum level allowed, which may be dependent on the magnitude of the voltage step magnitude.

9. A voltage source converter according to any of the preceding claims, ***characterized* in that** the semiconductor devices (26, 27) of the current valves are IGBTs (Insulated Gate Bipolar Transistors) or MOSFETs (Metal Oxide Semiconductor Field Effect Transistors).

10. A voltage source converter according to any of the preceding claims, ***characterized* in that** the rectifying diodes (28, 29) are bipolar diodes, and that the control units (35, 36) of the gate drive parts (33, 34) are configured to make the turn-on speed of the semiconductor device (26, 27) of the current valve (22, 23) controlled higher with a higher measure of the current (I) on said AC side determined.

11. A voltage source converter according to any of claims 1-8, ***characterized* in that** the rectifying diodes (28, 29) are unipolar diodes, and that the control unit (35, 36) of each gate drive part (33, 34) is configured to make the turn-on speed of the semiconductor device of the current valve controlling the voltage on the AC side slower with a higher measure of the current on said AC side (30) determined.

12. A voltage source converter according to any of the preceding claims, ***characterized* in that** it is a track-bound vehicle converter (6, 7, 12, 13) configured to be arranged on board a track-bound vehicle (1) and being for example a motor converter (13) configured to deliver power through said AC side of the converter to a motor (15) used to drive the vehicle or an auxiliary converter (7) configured to deliver a voltage on said AC side of the converter to be used for the heating/cooling system of the vehicle and for electrical appliances, such as through sockets arranged in said vehicle.

13. A method for controlling the turn-on of a semiconductor device (26, 27) of turn-off type in a voltage source converter which comprises a half bridge (21) with two current valves (22, 23) connected in series and configured to be connected to opposite poles (24, 25) of a DC source/load, each said current valve comprising a said semiconductor device and a rectifying diode (28, 29) connected in anti-parallel therewith, a midpoint of the half bridge between the two current valves forming an AC side (30) of the converter and being configured to be connected to an AC load/source (31), the voltage source converter being configured to be connected on its AC side to an inductive impedance,
***characterized* by** the steps of
• measuring the voltage (V_{f}) across the rectifying diode (28, 29) of each current valve (22, 23) at least during the half period of the AC current on said AC side (30) when the semiconductor device of the other current valve is controlling the voltage on the AC side,
• using the voltage (V_{f}) measured as a measure of the current (I) on said AC side (30), and
• making the turn on control of the semiconductor device (26, 27) of the current valve (22, 23) depending upon information about said measure so as to for each current minimize the total switching losses associated with the turn-on of the semiconductor switch while keeping the diode reverse recovery dV/dt of the diode (28, 29) of the current valve for which the semiconductor device is not controlling the voltage on the AC side below a maximum level allowed.

14. A track-bound vehicle having at least one converter according to any of claims 1-12.

## Patentansprüche

1. Spannungsquellenwandler umfassend
- eine Halbbrücke (21) mit zwei in Reihe geschalteten Stromventilen (22, 23), die dazu konfiguriert sind, mit entgegengesetzten Polen (24, 25) einer Gleichstromquelle/-last verbunden zu werden, wobei jedes Stromventil eine Halbleitervorrichtung (26, 27) vom Ausschalttyp und eine damit antiparallel geschaltete Gleichrichterdiode (28, 29) umfasst, wobei ein Mittelpunkt der Halbbrücke zwischen den beiden Stromventilen eine Wechselstromseite (30) des Wandlers bildet und zum Anschließen an eine Wechselstromlast/-quelle (31) konfiguriert ist, und
- eine Gate-Ansteuereinheit (32) mit einem ersten Gate-Ansteuerteil (33), der dazu konfiguriert ist, die Halbleitervorrichtung (26) eines ersten der Stromventile zu steuern, und einem zweiten Gate-Ansteuerteil (34), der dazu konfiguriert ist, die Halbleitervorrichtung (27) des anderen, zweiten der Stromventile zu steuern, um gemäß einem Impulsbreitenmodulationsmuster ein- und auszuschalten, um eine Wechselstrom-Grundspannung und eine Wechselstrom-Grundstrom auf der Wechselstromseite (30) zu erzeugen, wobei jeder Gate-Ansteuerteil eine Steuereinheit (35, 36) umfasst, die dazu konfiguriert ist, ein Ansteuerelement (37, 38) zu steuern, das dazu konfiguriert ist, Gate-Parameter der Halbleitervorrichtung zu beeinflussen, die von diesem Gate-Ansteuerteil gesteuert werden soll,
**dadurch gekennzeichnet, dass** der Wandler für jedes Stromventil (22, 23) ein Element (41, 42) umfasst, das dazu konfiguriert ist, zuerst die Spannung (V_{f}) über der Gleichrichterdiode (28, 29) des Stromventils zumindest während der halben Periode des Wechselstroms auf der Wechselstromseite zu messen, wenn die Halbleitervorrichtung (27, 26) des anderen Stromventils die Spannung auf der Wechselstromseite steuert, und zweitens Informationen über die gemessene Spannung an die Steuereinheit (35, 36) des Gate-Ansteuerteils zu senden, der dem anderen gesteuerten Stromventil zugeordnet ist, dass die Steuereinheit jedes Gate-Ansteuerteils (33, 34) dazu konfiguriert ist, die gemessene Spannung als Maß für den Strom (I) auf der Wechselstromseite zu verwenden und die Steuerung des Ansteuerelements (37, 38) davon in Abhängigkeit von Informationen dieses Maßes vorzunehmen, um die Gesamtschaltverluste zu minimieren, die mit dem Einschalten der Halbleitervorrichtung verbunden sind, während die Diodensperrverzögerung dV/dt der Diode (28, 29) des Stromventils, das die Spannung auf der Wechselstromseite Seite nicht regelt, immer noch unter einem maximal zulässigen Wert gehalten wird, und dass der Spannungsquellenwandler dazu konfiguriert ist, auf seiner Wechselstromseite mit einer induktiven Impedanz verbunden zu werden.

2. Spannungsquellenwandler nach Anspruch 1, **dadurch gekennzeichnet, dass** er für mindestens ein Stromventil (22, 23) ein Element (43, 44) umfasst, das dazu konfiguriert ist, die Temperatur dieses Ventils in der Nähe der Diode (28, 29) des Ventils zu messen und Informationen darüber mindestens an die Steuereinheit (35, 36) des dem anderen Stromventil zugeordneten Gate-Ansteuerteils zu senden, und dass die Steuereinheit jedes Gate-Ansteuerteils (33, 34) dazu konfiguriert ist, solche Temperaturinformationen (T) zu empfangen und diese Information auch als Parameter zu berücksichtigen, wenn das Maß des Stroms (I) auf der Wechselstromseite (30) bestimmt wird, und die Ansteuerung des Ansteuerelements (37, 38) auch abhängig von Informationen über den Wert der gemessenen Temperatur vorzunehmen.

3. Spannungsquellenwandler nach einem der vorhergehenden Ansprüche, **dadurch gekennzeichnet, dass** jeder Gate-Ansteuerteil (33, 34) einen Transceiver (48, 49) umfasst, der dazu konfiguriert ist, mit einem Transceiver (48, 49) des anderen Gate-Ansteuerteils zu kommunizieren, um diese Informationen zwischen den Gate-Ansteuerteilen zu übertragen.

4. Spannungsquellenwandler nach einem der vorhergehenden Ansprüche, **dadurch gekennzeichnet, dass** jedes Gate-Ansteuerteil (33, 34) eine Nachschlagetabelleneinheit (50, 51) umfasst, die dazu konfiguriert ist, die Informationen zu empfangen, die zum Bestimmen eines Maßes für den Strom (I) auf der Wechselstromseite (30) verwendet werden sollen, und das Maß für den Strom durch Vergleichen der Informationen mit Daten, die in Tabellen dieser Einheit gespeichert sind, zu bestimmen und Informationen dieses Maßes an die Steuereinheit (35, 36) des Gate-Ansteuerteils zu senden, der dazu konfiguriert ist, das Ansteuerelement (37, 38) in Abhängigkeit davon zu steuern.

5. Spannungsquellenwandler nach einem der Ansprüche 1 bis 3, **dadurch gekennzeichnet, dass** jeder Gate-Ansteuerteil (33, 34) eine Nachschlagetabelleneinheit (50, 51) umfasst, die dazu konfiguriert ist, diese Informationen zu empfangen und Werte für die Steuerung der Gate-Ansteuerung durch Vergleichen der Informationen mit in Tabellen gespeicherten Daten zu bestimmen, und die Werte an die Steuereinheit (35, 36) des Gate-Ansteuerteils zu senden, der dazu konfiguriert ist, das Ansteuerelement (37, 38) in Abhängigkeit davon zu steuern.

6. Spannungsquellenwandler nach einem der vorhergehenden Ansprüche, **dadurch gekennzeichnet, dass** die Gate-Ansteuerteile (33, 34) Ansteuerelemente (37, 38) in Form von Stromquellen aufweisen und die Steuereinheiten (35, 36) dazu konfiguriert sind, die Antriebselemente anzusteuern, um einen Einschaltstrom zu der Halbleitervorrichtung (26, 27) des zugehörigen Stromventils (22, 23) zu beeinflussen, welcher das Einschaltverhalten der Halbleitervorrichtung beeinflusst.

7. Spannungsquellenwandler nach einem der vorhergehenden Ansprüche, **dadurch gekennzeichnet, dass** jedes Gate-Ansteuerteil (33, 34) ein Ansteuerelement (37, 38) in Form einer Spannungsquelle und eines Gate-Widerstands aufweist und mindestens eine der Spannungsquellen und Gate-Widerstände steuerbar ist und dass die Steuereinheit (35, 36) dazu konfiguriert ist, das Ansteuerelement so zu steuern, dass es eine Gate-Spannung der Halbleitervorrichtung (26, 27) des zugeordneten Stromventils (22, 23) beeinflusst, die das Einschaltverhalten der Halbleitervorrichtung beeinflusst.

8. Spannungsquellenwandler nach einem der vorhergehenden Ansprüche, **dadurch gekennzeichnet, dass** es für mindestens ein Stromventil (22, 23) ein Element (41, 42) umfasst, das dazu konfiguriert ist, die Spannung an diesem Ventil zu messen, während es nicht leitet, und Informationen darüber an mindestens die Steuereinheit (35, 36) des Gate-Ansteuerteils zu senden, der demselben Stromventil zugeordnet ist, und dass die Steuereinheit jedes Gate-Ansteuerteils (33, 34) dazu konfiguriert ist, solche Spannungsinformationen (V_{ce}) zu empfangen und diese Informationen auch als Parameter zu verwenden, wenn die Steuerung des Ansteuerelements (37, 38) davon bestimmt wird, um die Gesamtschaltverluste, die mit dem Einschalten der Halbleitervorrichtung verbunden sind, zu minimieren, während die Diodensperrverzögerung dV/dt der Diode (28, 29) des Stromventils, das die Spannung auf der Wechselstromseite nicht regelt, noch unter einem maximal zulässigen Wert gehalten wird, der von der Größe der Spannungsstufengröße abhängen kann.

9. Spannungsquellenwandler nach einem der vorhergehenden Ansprüche, **dadurch gekennzeichnet, dass** die Halbleitervorrichtungen (26, 27) der Stromventile IGBTs (Insulated Gate Bipolar Transistors) oder MOSFETs (Metal Oxide Semiconductor Field Effect Transistors) sind.

10. Spannungsquellenwandler nach einem der vorhergehenden Ansprüche, **dadurch gekennzeichnet, dass** die Gleichrichterdioden (28, 29) bipolare Dioden sind und dass die Steuereinheiten (35, 36) der Gate-Ansteuerteile (33, 34) dazu konfiguriert sind, die Einschaltgeschwindigkeit der Halbleitervorrichtung (26, 27) des gesteuerten Stromventils (22, 23) zu erhöhen, wenn ein höheres Maß für den Strom (I) auf der Wechselstromseite bestimmt wird.

11. Spannungsquellenwandler nach einem der Ansprüche 1 bis 8, **dadurch gekennzeichnet, dass** die Gleichrichterdioden (28, 29) unipolare Dioden sind und dass die Steuereinheit (35, 36) jedes Gate-Ansteuerteils (33, 34) dazu konfiguriert ist, die Einschaltgeschwindigkeit der Halbleitervorrichtung des Stromventils, das die Spannung auf der Wechselstromseite steuert, zu verlangsamen, wenn ein höheres Maß für den Strom auf der Wechselstromseite (30) bestimmt wird.

12. Spannungsquellenwandler nach einem der vorhergehenden Ansprüche, **dadurch gekennzeichnet, dass** es sich um einen Wandler (6, 7, 12, 13) für spurgebundene Fahrzeuge handelt, der dazu konfiguriert ist, an Bord eines spurgebundenen Fahrzeugs (1) angeordnet zu sein, und beispielsweise ein Motorkonverter (13) ist, der dazu konfiguriert ist, Energie über die Wechselstromseite des Wandlers an einen Motor (15) zu liefern, der zum Antreiben des Fahrzeugs verwendet wird, oder ein Hilfswandler (7) ist, der dazu konfiguriert ist, eine Spannung auf der Wechselstromseite des Wandlers zu liefern, die für das Heiz-/Kühlsystem des Fahrzeugs und für Elektrogeräte, beispielsweise über in dem Fahrzeug angeordnete Steckdosen, verwendet wird.

13. Verfahren zum Steuern des Einschaltens einer Halbleitervorrichtung (26, 27) vom Ausschalttyp in einem Spannungsquellenwandler, der eine Halbbrücke (21) mit zwei in Reihe geschalteten Stromventilen (22, 23) umfasst, die dazu konfiguriert sind, mit entgegengesetzten Polen (24, 25) einer Gleichstromquelle/-last verbunden zu werden, wobei jedes Stromventil die Halbleitervorrichtung (26, 27) und eine damit antiparallel geschaltete Gleichrichterdiode (28, 29) umfasst, wobei ein Mittelpunkt der Halbbrücke zwischen den beiden Stromventilen eine Wechselstromseite (30) des Wandlers bildet und zum Anschließen an eine Wechselstromlast/-quelle (31) konfiguriert ist, wobei der Spannungsquellenwandler dazu konfiguriert ist, auf seiner Wechselstromseite mit einer induktiven Impedanz verbunden zu werden,
**gekennzeichnet durch** die Schritte
- Messen der Spannung (V_{f}) über der Gleichrichterdiode (28, 29) jedes Stromventils (22, 23) mindestens während der halben Periode des Wechselstroms auf der Wechselstromseite (30), wenn die Halbleitervorrichtung des anderen Stromventils die Spannung auf der Wechselstromseite regelt,
- Verwenden der gemessenen Spannung (V_{f}) als Maß für den Strom (I) auf der Wechselstromseite (30), und
- Durchführen der Einschaltsteuerung der Halbleitervorrichtung (26, 27) des Stromventils (22, 23) in Abhängigkeit von Informationen dieses Maßes derart, dass für jeden Strom die mit dem Einschalten des Halbleiterschalters verbundenen Gesamtschaltverluste minimiert werden, während die Diodensperrverzögerung dV/dt der Diode (28, 29) des Stromventils, für welches die Halbleitervorrichtung die Spannung auf der Wechselstromseite nicht regelt, unter einem maximal zulässigen Wert gehalten wird.

14. Spurgebundenes Fahrzeug mit mindestens einem Wandler nach einem der Ansprüche 1-12.

## Revendications

1. Convertisseur de source de tension comprenant
• un demi-pont (21) avec deux valves de courant (22, 23) connectées en série et configurées pour être connectées à des pôles (24, 25) opposés d'une source/charge CC, chacune desdites valves de courant comprenant un dispositif à semi-conducteur (26, 27) de type à désactivation et une diode redresseuse (28, 29) connectée en anti-parallèle avec celui-ci, un point médian du demi-pont entre les deux valves de courant formant un côté CA (30) du convertisseur et étant configuré pour être connecté à une charge/source CA (31), et
• une unité de pilotage de grille (32) ayant une première partie de pilotage de grille (33) configurée pour commander le dispositif à semi-conducteur (26) d'une première des valves de courant et une seconde partie de pilotage de grille (34) configurée pour commander le dispositif à semi-conducteur (27) de la seconde, autre, des valves de courant à activer et désactiver selon un profil de modulation d'impulsions en durée afin de créer une tension et un courant fondamentaux CA sur ledit côté CA (30), chaque partie de pilotage de grille comportant une unité de commande (35, 36) configurée pour commander un organe de pilotage (37, 38) configuré pour influencer des paramètres de grille du dispositif à semi-conducteur à commander par cette partie de pilotage de grille,
**caractérisé en ce que** le convertisseur comprend, pour chaque valve de courant (22, 23), un organe (41, 42) configuré pour d'abord mesurer la tension (V_{f}) aux bornes de ladite diode redresseuse (28, 29) de la valve de courant au moins pendant la demi-période du courant CA sur ledit côté CA lorsque le dispositif à semi-conducteur (27, 26) de l'autre valve de courant commande la tension sur le côté CA et deuxièmement envoyer des informations concernant la tension mesurée à l'unité de commande (35, 36) de la partie de pilotage de grille associée à ladite autre valve de courant commandée, **en ce que** l'unité de commande de chaque partie de pilotage de grille (33, 34) est configurée pour utiliser la tension mesurée en tant que mesure du courant (I) sur ledit côté CA et effectuer la commande dudit organe de pilotage (37, 38) de celui-ci en fonction d'informations concernant ladite mesure de façon à minimiser les pertes de commutation totales associées à l'activation du dispositif à semi-conducteur tout en maintenant la récupération inverse de diode dV/dt de la diode (28, 29) de la valve de courant ne commande pas la tension sur le côté CA en dessous d'un niveau maximal admis, et **en ce que** le convertisseur de source de tension est configuré pour être connecté sur son côté CA à une impédance inductive.

2. Convertisseur de source de tension selon la revendication 1, **caractérisé en ce qu'**il comprend, pour au moins une valve de courant (22, 23), un organe (43, 44) configuré pour mesurer la température de cette valve à proximité de la diode (28, 29) de la valve et envoyer des informations à ce sujet à au moins l'unité de commande (35, 36) de la partie de pilotage de grille associée à l'autre valve de courant, et **en ce que** l'unité de commande de chaque partie de pilotage de grille (33, 34) est configurée pour recevoir ces informations de température (T) et tenir compte également de ces informations en tant que paramètre lors de la détermination de la mesure du courant (I) sur ledit côté CA (30) et effectuer la commande dudit organe de pilotage (37, 38) de celle-ci également en fonction d'informations concernant la valeur de la température mesurée.

3. Convertisseur de source de tension selon l'une quelconque des revendications précédentes, **caractérisé en ce que** chaque partie de pilotage de grille (33, 34) comprend un émetteur-récepteur (48, 49) configuré pour communiquer avec un émetteur-récepteur (48, 49) de l'autre partie de pilotage de grille de façon à transmettre lesdites informations entre les parties de pilotage de grille.

4. Convertisseur de source de tension selon l'une quelconque des revendications précédentes, **caractérisé en ce que** chaque partie de pilotage de grille (33, 34) comprend une unité de table de consultation (50, 51) configurée pour recevoir lesdites informations à utiliser afin de déterminer une mesure du courant (I) sur ledit côté CA (30) et déterminer ladite mesure du courant en comparant lesdites informations à des données stockées dans des tables de cette unité et envoyer des informations de cette mesure à l'unité de commande (35, 36) de cette partie de pilotage de grille configurée pour commander l'organe de pilotage (37, 38) en fonction de celles-ci.

5. Convertisseur de source de tension selon l'une quelconque des revendications 1 à 3, **caractérisé en ce que** chaque partie de pilotage de grille (33, 34) comprend une unité de table de consultation (50, 51) configurée pour recevoir lesdites informations et déterminer des valeurs pour la commande du pilotage de grille en comparant lesdites informations à des données stockées dans des tables et envoyer les valeurs à l'unité de commande (35, 36) de cette partie de pilotage de grille configurée pour commander l'organe de pilotage (37, 38) en fonction de celles-ci.

6. Convertisseur de source de tension selon l'une quelconque des revendications précédentes, **caractérisé en ce que** les parties de pilotage de grille (33, 34) ont des organes de pilotage (37, 38) sous la forme de sources de courant et les unités de commande (35, 36) sont configurées pour commander les organes de pilotage afin d'influencer un courant d'activation au dispositif à semi-conducteur (26, 27) de la valve de courant (22, 23) associée influençant le comportement d'activation du dispositif à semi-conducteur.

7. Convertisseur de source de tension selon l'une quelconque des revendications précédentes, **caractérisé en ce que** chaque partie de pilotage de grille (33, 34) a un organe de pilotage (37, 38) sous la forme d'une source de tension et d'un résistor de grille et au moins l'un de ladite source de tension et dudit résistor de grille peut être commandé et **en ce que** l'unité de commande (35, 36) est configurée pour commander l'organe de pilotage afin d'influencer une tension de grille du dispositif à semi-conducteur (26, 27) de la valve de courant (22, 23) associée influençant le comportement d'activation du dispositif à semi-conducteur.

8. Convertisseur de source de tension selon l'une quelconque des revendications précédentes, **caractérisé en ce qu'**il comprend, pour au moins une valve de courant (22, 23), un organe (41, 42) configuré pour mesurer la tension aux bornes de cette valve tandis qu'il n'est pas conducteur et envoyer des informations à ce sujet à au moins l'unité de commande (35, 36) de la partie de pilotage de grille associée à la même valve de courant, et **en ce que** l'unité de commande de chaque partie de pilotage de grille (33, 34) est configurée pour recevoir ces informations de tension (V_{ce}) et utiliser également ces informations en tant que paramètre lors de la détermination de la commande dudit organe de pilotage (37, 38) de celle-ci afin de minimiser les pertes de commutation totales associées à l'activation du dispositif à semi-conducteur tout en maintenant la récupération inverse de diode dV/dt de la diode (28, 29) de la valve de courant ne commande pas la tension sur le côté CA en dessous d'un niveau maximal admis, qui peut être fonction de la grandeur de la grandeur de pas de tension.

9. Convertisseur de source de tension selon l'une quelconque des revendications précédentes, **caractérisé en ce que** les dispositifs à semi-conducteur (26, 27) des valves de courant sont des IGBT (transistors bipolaires à grille isolée) ou des MOSFET (transistors à effet de champ métal-oxyde semi-conducteurs).

10. Convertisseur de source de tension selon l'une quelconque des revendications précédentes, **caractérisé en ce que** les diodes redresseuses (28, 29) sont des diodes bipolaires, et **en ce que** les unités de commande (35, 36) des parties de pilotage de grille (33, 34) sont configurées pour rendre la vitesse d'activation du dispositif à semi-conducteur (26, 27) de la valve de courant (22, 23) commandée plus élevée avec une mesure plus élevée du courant (I) sur ledit côté CA déterminée.

11. Convertisseur de source de tension selon l'une quelconque des revendications 1 à 8, **caractérisé en ce que** les diodes redresseuses (28, 29) sont des diodes unipolaires, et **en ce que** l'unité de commande (35, 36) de chaque partie de pilotage de grille (33, 34) est configurée pour rendre la vitesse d'activation du dispositif à semi-conducteur de la valve de courant commandant la tension sur le côté CA plus lente avec une mesure plus élevée du courant sur ledit côté CA (30) déterminée.

12. Convertisseur de source de tension selon l'une quelconque des revendications précédentes, **caractérisé en ce qu'**il s'agit d'un convertisseur de véhicule sur voie (6, 7, 12, 13) configuré pour être agencé à bord d'un véhicule sur voie (1) et étant par exemple un convertisseur de moteur (13) configuré pour délivrer de la puissance par le biais dudit côté CA du convertisseur à un moteur (15) utilisé pour entraîner le véhicule ou un convertisseur auxiliaire (7) configuré pour délivrer une tension sur ledit côté CA du convertisseur à utiliser pour le système de chauffage/refroidissement du véhicule et pour des appareils électriques, comme par le biais de prises agencées dans ledit véhicule.

13. Procédé de commande de l'activation d'un dispositif à semi-conducteur (26, 27) du type à désactivation dans un convertisseur de source de tension qui comprend un demi-pont (21) avec deux valves de courant (22, 23) connectées en série et configurées pour être connectées à des pôles (24, 25) opposés d'une source/charge CC, chacune de ladite valve de courant comprenant un dispositif à semi-conducteur et une diode redresseuse (28, 29) connectée en anti-parallèle avec celui-ci, un point médian du demi-pont entre les deux valves de courant formant un côté CA (30) du convertisseur et étant configuré pour être connecté à une charge/source CA (31), le convertisseur de source de tension étant configuré pour être connecté sur son côté CA à une impédance inductive,
**caractérisé par** les étapes consistant à
• mesurer la tension (V_{f}) aux bornes de la diode redresseuse (28, 29) de chaque valve de courant (22, 23) au moins pendant la demi-période du courant CA sur ledit côté CA (30) lorsque le dispositif à semi-conducteur de l'autre valve de courant commande la tension sur le côté CA,
• utiliser la tension (V_{f}) mesurée en tant que mesure du courant (I) sur ledit côté CA (30), et
• effectuer la commande d'activation du dispositif à semi-conducteur (26, 27) de la valve de courant (22, 23) en fonction d'informations concernant ladite mesure de façon, pour chaque courant, à minimiser les pertes de commutation totales associées à l'activation du commutateur à semi-conducteur tout en maintenant la récupération inverse de diode dV/dt de la diode (28, 29) de la valve de courant pour laquelle le dispositif à semi-conducteur ne commande pas la tension sur le côté CA en dessous d'un niveau maximal admis.

14. Véhicule sur voie ayant au moins un convertisseur selon l'une quelconque des revendications 1 à 12.
